# EUROPEAN PATENT APPLICATION

(11) **EP 0 572 212 A2**
(43) Date of publication of application: **01.12.1993**
(21) Application number: 93304035.4
(22) Date of filing: 25.05.1993
(51) Int. Cl.: H01L 21/285

(54) **Method to form silicon doped CVD aluminium**

(30) Priority: 29.05.1992 US 890920
(71) Applicant: SGS-THOMSON MICROELECTRONICS, INC., Carrollton Texas 75006 (US)
(72) Inventor: Chan, Tsiu Chiu, Carrollton, Texas 75006 (US); Bryant, Frank Randolph, Denton, Texas 76201 (US)
(74) Representative: Palmer, Roger

(57) **Abstract**

An insulating layer (12) is formed over a substrate (10). An opening (14) is formed in the insulating layer (12) exposing a portion of the substrate (10). A substantially conformal aluminum layer (18) is formed by CVD over the insulating layer (12) and in the opening (14). Silicon is formed in the CVD aluminum layer (18) to a concentration substantially equal to the solubility coefficient of silicon in aluminum.

## Description

The present invention relates generally to semiconductor integrated circuit processing, and more specifically to forming a silicon doped CVD aluminum.

Chemical vapor deposition (CVD) technology has become more common in the fabrication of VLSI circuits as the need to achieve higher film qualities and smaller dimensions increases. Many films today can be deposited by CVD techniques in which a material is deposited intact on the surface of the wafer. The CVD reaction requires the addition of energy to the chamber or wafer as the proper mixture and reaction of chemicals take place to produce the final desired film.

CVD systems are divided into two categories: atmospheric pressure CVD (APCVD) systems and low pressure CVD (LPCVD) systems. APCVD reactions take place, as the name indicates, at atmospheric pressure. APCVD systems depend on temperature control and mass flow to control the process to provide a uniform layer. LPCVD, on the other hand, lowers the pressure in the reaction chamber, thus lowering the required deposition temperature. A lower deposition temperature increases the mean free path of the molecules, or the average distance that a single molecule will travel before colliding with another molecule, the wafer, the wafer holder, or the inside of the chamber. The longer the mean free path of the molecules, the more uniform the deposited layer will have in addition to better step coverage.

Prior to the development of VLSI circuits, aluminum was the primary metallization material. Aluminum has a relatively low resistivity and adequate current carrying capacity. However, there are problems with the use of pure aluminum in VLSI circuits. At aluminum-silicon interfaces, particularly in shallow junctions, the silicon dissolves into the aluminum. There are two generally accepted solutions to prevent the silicon from dissolving into the aluminum. The first is to use a barrier metal layer to separate the silicon and aluminum without reducing the current carrying capacity or increase the resistance. The second is to form an aluminum alloy comprising approximately 1-2 percent of silicon.

In order to achieve an aluminum alloy having the right concentration of silicon, the aluminum and silicon are sputter deposited in a vacuum chamber. This process is a physical vapor deposition in argon gas. A direct benefit of sputter deposition is the ability to deposit alloys. The aluminum and silicon atoms are sputtered onto the surface of the wafer achieving the right percentage composition and without a chemical change. Even though the aluminum and silicon atoms are sputtered onto the surface at various angles, step coverage of the aluminum is not as uniform as when the aluminum is formed by CVD methods.

LPCVD aluminum produces near conformal layers over steps and into interconnect openings. However, incorporating silicon into the aluminum during deposition is difficult to control due to a difference in chemical reactions between the two materials during the deposition process. It would be desirable to form an aluminum-silicon alloy which forms a near conformal layer over steps and into openings.

It is therefore an object of the this invention to provide a method of forming a near conformal aluminum layer.

It is a further object of this invention to provide such a method which forms aluminum by low pressure chemical vapor deposition techniques.

It is a further object of this invention to provide such a method which forms an aluminum-silicon alloy.

It is a further object of this invention to provide such a method which utilizes conventional process flows.

Other objects and advantages of the invention will be apparent to those of ordinary skill in the art having reference to the following specification together with the drawings.

The invention may be incorporated into a method for forming a semiconductor device structure, and the semiconductor device structure formed thereby, by forming an insulating layer over a substrate. An opening in the insulating layer is formed exposing a portion of the substrate. A substantially conformal aluminum layer is formed by CVD over the insulating layer and in the opening wherein the CVD aluminum layer has a silicon concentration substantially equal to the solubility coefficient of silicon in aluminum.

The novel features believed characteristic of the invention are set forth in the appended claims. The invention itself, however, as well as a preferred mode of use, and further objects and advantages thereof, will best be understood by reference to the following detailed description of illustrative embodiments when read in conjunction with the accompanying drawings, wherein:

**Figure 1** is a cross sectional view of the fabrication of a semiconductor integrated circuit according to the present invention.

**Figure 2** is a cross sectional view of the fabrication of a alternative fabrication method of a semiconductor integrated circuit according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

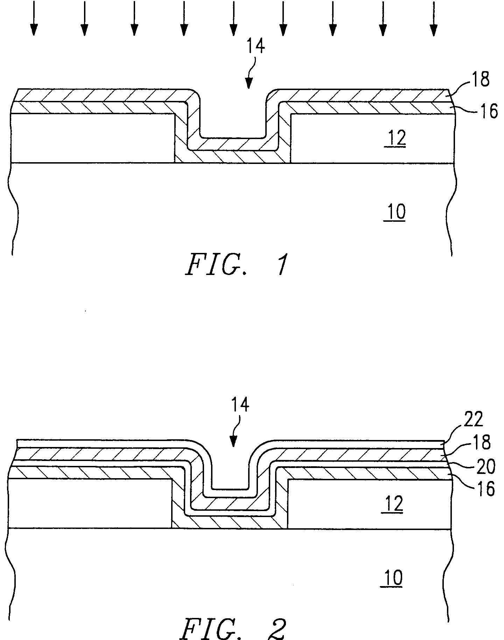

Referring to Figure 1, an integrated circuit is to be formed on a silicon substrate 10. An interlevel dielectric layer 12 is formed by conventional methods over the substrate 10. An opening 14 is formed in the dielectric layer 12 to expose a portion of the substrate 10. A barrier layer 16 may be formed over the dielectric layer 12 and in the opening 14. Layer 16 will typically be a refractory metal such as titanium or tungsten or a refractory metal silicide. An aluminum layer 18 is formed over the barrier layer 16 and in the opening 14.

The aluminum layer 18 is formed by chemical vapor deposition (CVD) techniques and preferably by low pressure CVD (LPCVD) to obtain a near conformal layer over the integrated circuit. For purposes of simplicity, the invention will refer to LPCVD aluminum techniques. The LPCVD aluminum deposition techniques will increase step coverage and provide a more conformal layer into interconnect openings. Silicon is then implanted into the aluminum to achieve a desired silicon concentration. An example of an implanted dosage is 6 X 10¹⁶ atoms/cm² implanted into approximately 10,000 angstroms of aluminum to achieve approximately a one percent by weight silicon concentration in the aluminum. The appropriate concentration of silicon in the aluminum to create an aluminum-silicon alloy will prevent any substantial amount of silicon from the substrate from dissolving into the aluminum layer.

Referring to Figure 2, an alternative method of forming the aluminum-silicon alloy is shown. The process steps of forming the interlevel dielectric layer 12, the opening 14 and barrier layer 16, if formed, are the same as described above. A silicon layer 20 is deposited over the barrier layer 16 and in the opening 14. A substantially conformal aluminum layer 18 is then formed by LPCVD techniques over the silicon layer 20. During subsequent processing steps, the silicon layer 20 will dissolve into the aluminum layer 18. Alternatively, a silicon layer 22 may be formed over the conformal aluminum layer 18 after the aluminum layer is formed. Again, during subsequent processing steps, the silicon layer 22 will dissolve into the aluminum layer 18. The silicon layers 20 and 22 may be formed by sputter deposition techniques or by plasma enhanced chemical vapor deposition techniques to a desired thickness to form the necessary aluminum-silicon alloy. For example, approximately 120 angstroms of silicon will produce approximately a one percent by weight silicon concentration in approximately 10,000 angstroms of aluminum.

Even with today's barrier technology, silicon must still be used as a dopant in the aluminum films to prevent the silicon in the substrate from migrating across the barrier into the aluminum during subsequent processing steps. The invention described above may also be used between aluminum and polysilicon upper layers such as those used for signal lines and other contact vias. Using the silicon as a dopant in the aluminum will thus prevent junction spiking by providing a silicon concentration substantially equal to the solubility coefficient of the silicon in aluminum at any given temperature during subsequent processing steps. Aluminum-silicon alloys are currently used in todays technology typically by sputter deposition of both the aluminum and silicon. The primary advantage of the present invention is the formation of the aluminum by LPCVD techniques to provide a more conformal layer while still providing an aluminum-silicon alloy having the necessary concentration of silicon in the aluminum.

While the invention has been particularly shown and described with reference to a preferred embodiment, it will be understood by those skilled in the art that various changes in form and detail may be made therein without departing from the spirit and scope of the invention.

## Claims

1. A method of forming a silicon doped CVD aluminum layer of a semiconductor integrated circuit, comprising the steps of:
forming an insulating layer over a substrate;
forming an opening in the insulating layer exposing a portion of the substrate;
depositing a substantially conformal aluminum layer by CVD over the insulating layer and in the opening wherein the CVD aluminum layer has a silicon concentration substantially equal to the solubility coefficient of silicon in aluminum.

2. The method of claim 1, wherein the silicon is formed in the CVD aluminum layer after the aluminum layer is formed.

3. A method of forming a silicon doped CVD aluminum layer of a semiconductor integrated circuit, comprising the steps of:
forming an insulating layer over a substrate;
forming an opening in the insulating layer exposing a portion of the substrate;
depositing a substantially conformal aluminum layer by CVD over the insulating layer and in the opening; and
forming silicon in the CVD aluminum layer to a concentration substantially equal to the solubility coefficient of silicon in aluminum.

4. The method of claim 3 wherein the silicon forming step comprises implanting silicon into the CVD formed aluminum layer.

5. The method of claim 4 wherein the amount of silicon implanted will be substantially equal to one percent by weight of silicon concentration in the aluminum layer.

6. The method of claim 3 wherein the silicon forming step comprises sputter deposition of the silicon on the insulating layer and in the opening before the CVD aluminum layer is formed.

7. The method of claim 3 wherein the silicon forming step comprises sputter deposition of the silicon over the CVD aluminum layer.

8. The method of claim 3 wherein the silicon forming step comprises plasma enhanced CVD of the silicon on the insulating layer and in the opening before the CVD aluminum layer is formed.

9. The method of claim 3 wherein the silicon forming step comprises plasma enhanced CVD of the silicon over the CVD aluminum layer.

10. The method of claim 3 further comprising the step of forming a barrier layer over the insulating layer and in the opening before the CVD aluminum layer is formed.

11. A structure consisting of a portion of an integrated circuit device, comprising:
a substrate;
an interlevel dielectric layer having an opening therethrough exposing a portion of the substrate;
a substantially conformal aluminum layer disposed over the interlevel dielectric layer and in the opening wherein the aluminum layer is formed by the process of CVD and wherein the aluminum has a silicon concentration substantially equal to the solubility of silicon in aluminum.

12. The structure of claim 11 wherein the silicon concentration in the CVD aluminum is formed by a process of implanting silicon into the CVD aluminum layer.

13. The structure of claim 11 wherein the silicon concentration in the CVD aluminum is formed by a process of sputter deposition of the silicon into the opening and between the insulating layer and the CVD aluminum layer.

14. The structure of claim 11 wherein the silicon concentration in the CVD aluminum is formed by a process of sputter deposition of the silicon over the CVD aluminum layer.

15. The structure of claim 11 wherein the silicon concentration in the CVD aluminum is formed by a process of plasma enhanced CVD of the silicon on the insulating layer and in the opening between. the insulating layer and the CVD aluminum layer.

16. The structure of claim 11 wherein the silicon concentration in the CVD aluminum is formed by a process of plasma enhanced CVD of the silicon over the CVD aluminum layer.

17. The method of claim 1 or 3, or the structure of claim 11, wherein the CVD process is LPCVD.
